# EUROPEAN PATENT APPLICATION

(11) **EP 3 926 834 A1**
(43) Date of publication of application: **22.12.2021**
(21) Application number: 20213608.1
(22) Date of filing: 11.12.2020
(51) Int. Cl.: H03M 13/11

(54) **LDPC DECODER APPARATUS, DEVICE, SYSTEM, METHOD AND COMPUTER PROGRAM**

(30) Priority: 18.06.2020 US 202016904656
(71) Applicant: INTEL Corporation, Santa Clara, CA 95054 (US)
(72) Inventor: KWOK, Zion, Burnaby, BC V5H 4J3 (CA)
(74) Representative: 2SPL Patentanwälte PartG mbB

(57) **Abstract**

Examples relate to a Low-Density Parity-Check Code (LDPC) decoder apparatus or device, to an LDPC decoder system and to corresponding methods and computer programs. The LDPC decoder apparatus comprises input circuitry and processing circuitry. The processing circuitry is configured to obtain a syndrome of a codeword via the input circuitry. The processing circuitry is configured to perform LDPC iterative decoding using the obtained syndrome, wherein the changes to be applied to the codeword due to the LDPC iterative decoding are recorded by applying the changes to a surrogate codeword. The processing circuitry is configured to record changes to be applied to the codeword due to the LDPC iterative decoding by storing the surrogate codeword in a memory structure.

## Description

### Field

Examples relate to a Low-Density Parity-Check Code, LDPC, decoder apparatus or device, to an LDPC decoder system and to corresponding methods and computer programs.

### Background

Forward error correction codes and systems are being used in various contexts, e.g. in communication systems for transmitting data over a lossy channel, or in memory or storage applications for recovering bit errors or faulty memory or storage circuitry. One technique being used for providing forward error correction is based on so-called "Low-Density Parity-Check Codes" (LDPC), which are codes that are based on a sparse matrix (i.e. a matrix where most of the elements are logical 0s) that can be used to recover a codeword.

### Brief description of the Figures

Some examples of apparatuses and/or methods will be described in the following by way of example only, and with reference to the accompanying figures, in which
- Figs. 1a and 1b: show block diagrams of examples of an LDPC decoder apparatus or device and of an LDPC decoder system;
- Fig. 1c: shows a flow chart of an example of an LDPC decoder method;
- Fig. 2: shows a block diagram of an example of a communication device comprising an LDPC decoder system;
- Fig. 3: shows a block diagram of an example of a memory device comprising an LDPC decoder system;
- Fig. 4: shows a block diagram of an example of a storage device comprising an LDPC decoder system;
- Fig. 5a: shows a schematic diagram of an interrelationship between an LDPC H matrix, variable bit nodes and check nodes;
- Fig. 5b: shows a schematic diagram of an LDPC decoding flow;
- Fig. 6: shows a schematic diagram of an example of another representation of an interrelationship between an LDPC H matrix, variable bit nodes and check nodes;
- Fig. 7: shows a schematic diagram of a similarity between a generation of an error vector and a correction of a corrupted codeword;
- Fig. 8: shows a schematic diagram of an LDPC decoding flow according to an example;
- Fig. 9: shows a schematic diagram of an example of another representation of an interrelationship between an LDPC H matrix, variable bit nodes and check nodes;
- Fig. 10a: shows a schematic diagram of an example of a variable node update logic for a min-sum decoder;
- Fig. 10b: shows a schematic diagram of an example of a check node update logic for a minsum decoder;
- Fig. 10c: shows a schematic diagram of an example of a variable node update logic for a bitflipping decoder;
- Fig. 10d: shows a schematic diagram of an example of a check node update logic for a bitflipping decoder;
- Fig. 11: shows a Tanner graph representing an LDPC code;
- Fig. 12a: shows an exemplary flow of a low-complexity LDPC decoder;
- Fig. 12b: shows a flow of an LDPC decoder according to an example; and
- Fig. 13: shows a schematic diagram of an example of an architecture of a syndrome-based bit flipping algorithm.

### Detailed Description

Some examples are now described in more detail with reference to the enclosed figures. However, other possible examples are not limited to the features of these examples described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an 'or', this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

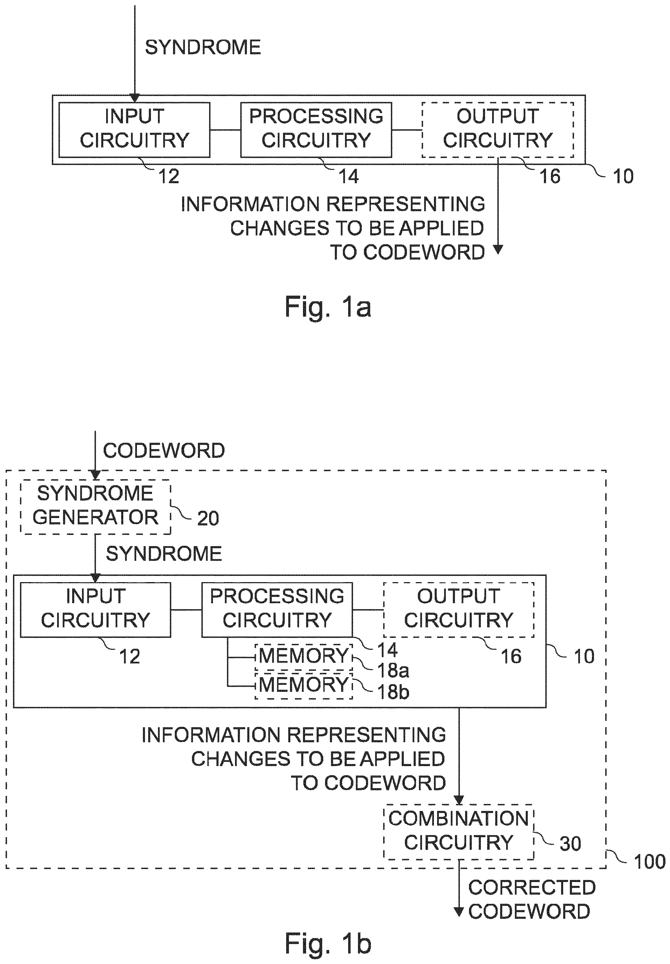

Figs. 1a and 1b show block diagrams of examples of an LDPC decoder apparatus or device 10. The components of the LDPC decoder device are introduced as component means, which may correspond to the respective structural components of the LDPC decoder apparatus. Therefore, in the following, the component means are introduced in parentheses following the respective structural components of the LDPC decoder apparatus. The LDPC decoder apparatus comprises input circuitry (or input means) 12, (optional) output circuitry (or output means) 16 and processing circuitry (or means for processing) 14. The processing circuitry is coupled with the input circuitry and the output circuitry. In general, the processing functionality of the LDPC decoder apparatus (or device) is provided by the processing circuitry, with input and output functionality being provided by the respective input or output circuitry. In various examples, the processing circuitry comprises memory circuitry for storing intermediate values, or for connecting different portions of the processing circuitry. The processing circuitry is configured to obtain a syndrome of a codeword via the input circuitry. The processing circuitry is configured to perform LDPC iterative decoding using the obtained syndrome. The changes to be applied to the codeword due to the LDPC iterative decoding are recorded by applying the changes to a surrogate codeword. For example, the surrogate codeword is initialized with all zeros during an initialization of the LDPC iterative decoding. The processing circuitry is configured to record changes to be applied to the codeword due to the LDPC iterative decoding by storing the surrogate codeword in a memory structure (of the processing circuitry, or more generally, the LDPC decoder apparatus). The processing circuitry may be configured to output information representing the changes to be applied to the codeword via the output circuitry.

Fig. 1b further shows an example of an LDPC decoder system 100, which comprises the LDPC decoder apparatus (or LDPC decoder device) 10. The LDPC decoder system further comprises syndrome generation circuitry (or means for generating a syndrome) 20 configured to generate the syndrome based on the codeword, and to provide the syndrome to the LDPC decoder apparatus. The LDPC decoder system further comprises combination circuitry (or combination means) 30 configured to combine an output of the LDPC decoder apparatus with the codeword, and to output the combination.

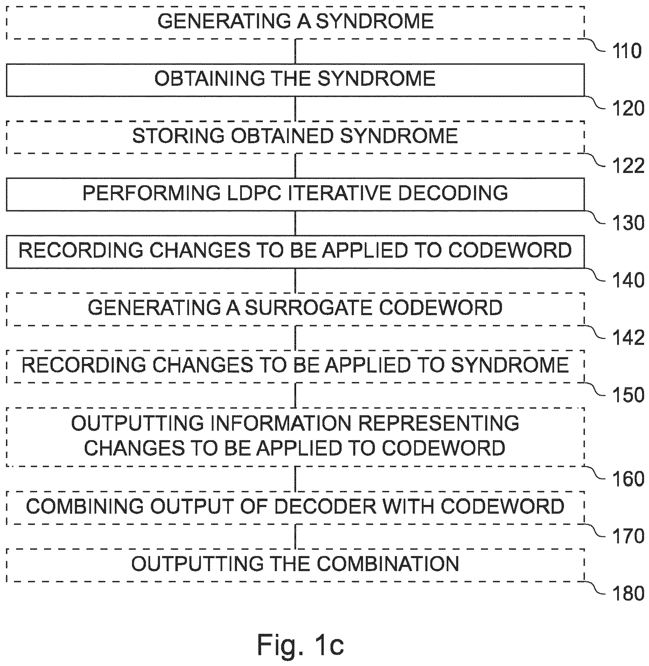

Fig. 1c shows a flow chart of an example of a corresponding LDPC decoder method. The method comprises obtaining 120 a syndrome of a codeword via an input. The method comprises performing LDPC iterative decoding 130 using the obtained syndrome. The changes to be applied to the codeword due to the LDPC iterative decoding are recorded by applying the changes to a surrogate codeword. The surrogate codeword may be initialized with all zeros during an initialization of the LDPC iterative decoding. The method comprises recording changes 140 to be applied to the codeword due to the LDPC iterative decoding by storing the surrogate codeword in a memory structure. The method may comprise outputting 160 information representing the changes to be applied to the codeword via an output. Optionally, the method comprises generating 110 a syndrome based on a codeword. Optionally, the method comprises combining 170 the output of the LDPC decoder method with the codeword. Optionally, the method comprises outputting 180 the combination.

The following description relates to the LDPC decoder apparatus/device and system and to the corresponding method or methods. Features of the apparatus/device or method may be likewise applied to the corresponding method.

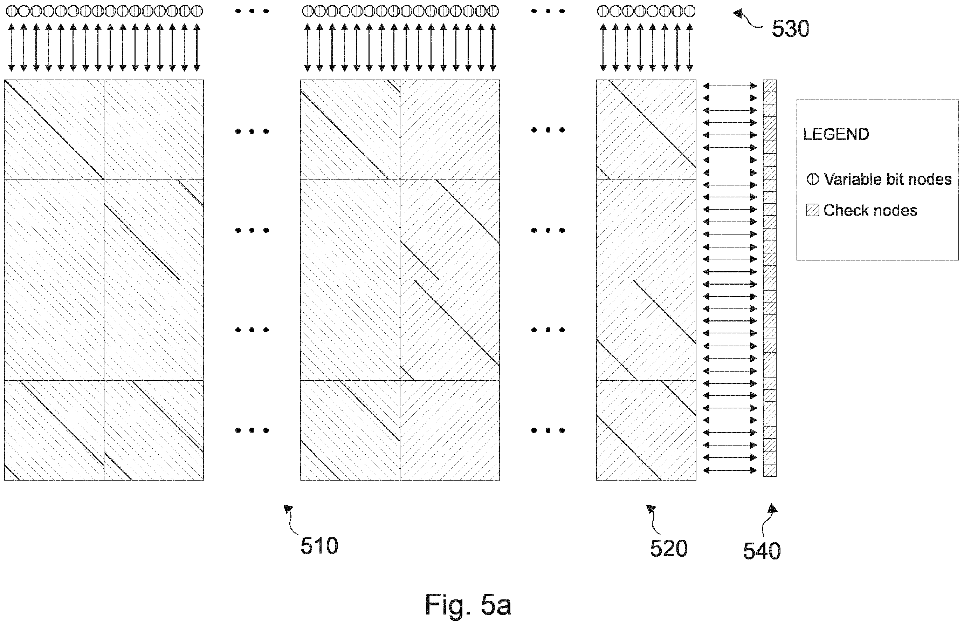

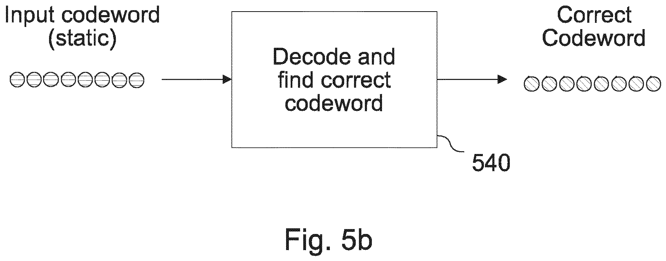

Various examples of the present disclosure relate to an LDPC decoder apparatus or device, to a system comprising such an LDPC decoder apparatus or device, and to a corresponding method. As has been mentioned before, LDPC are codes that are being used to provide both error detection and error correction for codewords comprising LDPC parity information. Such codewords are, for example, used in communication systems for transmitting information over a lossy channel, or in memory or storage applications, where transmission and/or memory/storage errors can be recovered using such codes. In general, an LDPC decoder takes a codeword as an input, and uses a so-called parity-check matrix (also called H matrix) to calculate a syndrome of the codeword (using a matrix multiplication). The component "low-density" in LDPC refers to the sparseness of the H matrix, in which only few non-zero elements (e.g. logical ones, or other non-binary values when a non-binary LDPC code is used) are interspersed among zeros. In the Figures shown in later parts of the disclosure, e.g. Fig. 5, the non-zero elements in the matrix are indicated by the diagonal lines across the matrix. The syndrome indicates whether the codeword is correct - if the syndrome is 0 (i.e. all bits of the logical syndrome are logical 0) the codeword is correct. If not, or rather as long as this is not the case (and a maximal number of iterations has not been reached), an iterative process involving message passing is used to correct the code word, by passing "messages" between the variable bit nodes (of the codeword) and the so-called check nodes (of the syndrome) according to a decoder algorithm. In various examples of the present disclosure, this general concept is adapted to work without the actual codeword - instead of the codeword, the decoder accepts the syndrome at its input, and the result of the iterative decoding is combined with the codeword to provide the corrected codeword.

Accordingly, the syndrome may be calculated beforehand, and then passed to the LDPC decoder apparatus. In other words, the syndrome may be initially computed outside the LDPC decoder apparatus. The codeword might not be provided to the LDPC decoder apparatus. In various examples, the syndrome generation circuitry 20 is used to generate the syndrome that is input into the LDPC decoder apparatus. In general, the syndrome generation circuitry may be application-specific circuitry configured to calculate the syndrome based on the codeword using a hardware- or software-implementation of a matrix multiplication using the respective H-matrix. For example, the syndrome generation circuitry may be implemented using application-specific hardware (e.g. with a memory storing a representation of the H matrix), or a general-purpose processor equipped with corresponding software may be used to implement the syndrome generation circuitry. The processing circuitry of the LDPC decoder apparatus is configured to obtain the syndrome of the codeword via the input circuitry, e.g. from the syndrome generation circuitry 20. The processing circuitry might not be configured to obtain the actual codeword, i.e. the processing circuitry might not accept the codeword via the input circuitry.

The processing circuitry is configured to perform LDPC iterative decoding using the obtained syndrome. In general, the LDPC iterative decoding being performed by the processing circuitry may be implemented similar to other systems, with at least one major difference - instead of applying the changes to be applied during the LDPC iterative decoding to the codeword, the changes are instead applied to a so-called surrogate codeword, i.e. bit vector having (generally) the same size as the actual codeword, but which is initialized with all zeros. For example, the surrogate codeword is used by the processing circuitry for the LDPC iterative decoding instead of the codeword. As a result of the LDPC iterative decoding, instead of the corrected codeword, the surrogate codeword represents the changes (e.g. bit flips) to be applied to the actual codeword. In other words, after the LDPC iterative decoding, the surrogate codeword may represent the difference between the corrected codeword and the codeword. In other words, after the LDPC iterative decoding is completed, the surrogate codeword represents the changes to be applied to the codeword. In general, the concept may be applied to various hard decoding or soft decoding approaches. For example, the LDPC iterative decoding may be performed using one of a belief propagation algorithm, a sum-product message-passing algorithm, a min-sum algorithm, and a bit-flipping algorithm. In the non-binary LDPC case, the iterative decoding may be performed using one of belief propagation algorithm, a min-max algorithm, an extended min-sum algorithm, a trellis min-sum algorithm, a symbol flipping algorithm, or a non-binary stochastic decoder.

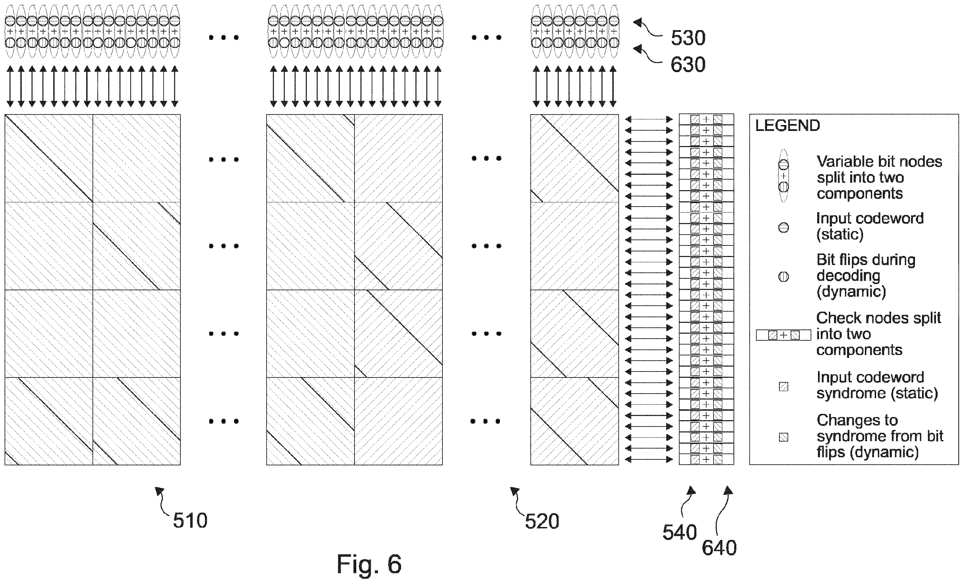

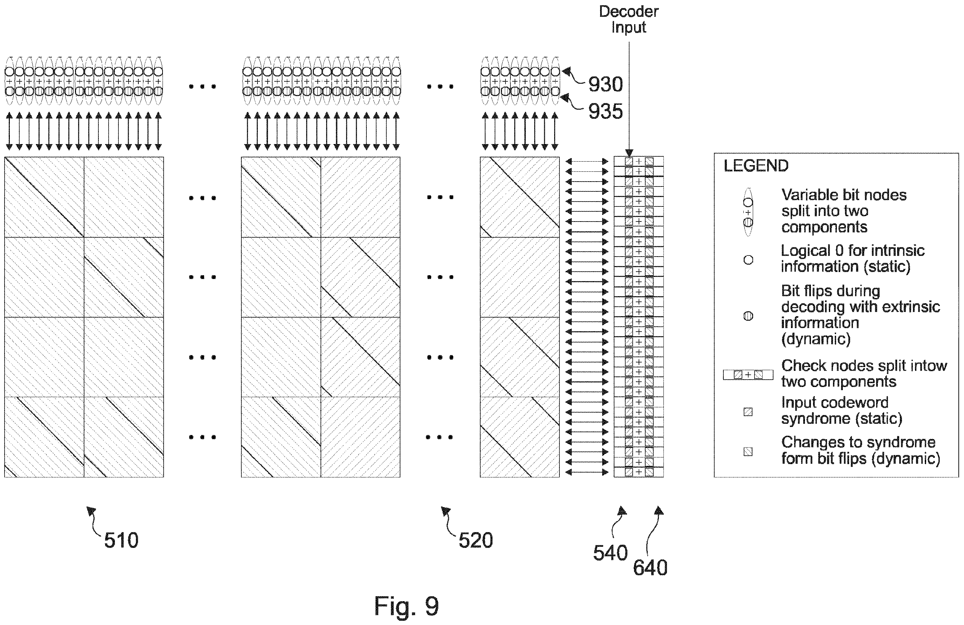

The processing circuitry is configured to record the changes to be applied to the codeword due to the LDPC iterative decoding by storing the surrogate codeword in a memory structure, e.g. within flip-flops/random access memory (RAM) of the processing circuitry. As shown in Fig. 1b, the LDPC decoder apparatus may comprise memory circuitry (i.e. memory, such as flip-flops or RAM) 18a for storing the memory structure. In general, two approaches may be taken - either the surrogate codeword may be stored in full in the memory structure, i.e. the memory structure may comprise enough bits to store the entire surrogate codeword. In other words, the memory structure for recording the changes to be applied to the codeword may be used to store each bit of the surrogate codeword. Such an approach is e.g. shown in Figs. 6 and 9, where the surrogate codeword that represents the bit flips that occur during the LDPC iterative decoding is stored 630; 935 for every bit of the codeword. Consequently, the entire surrogate codeword may be stored in the memory structure. Alternatively, as there are usually only few changes necessary for correcting the codeword, additional logic may be employed to store (only) the relevant (i.e. changed) bits of the surrogate codeword. For example, the memory structure for recording the changes to be applied to the codeword may be used to store (only) the bits of the surrogate codeword that are changed due to the LDPC iterative decoding. The processing circuitry may comprise logic, e.g. be configured, to store (only) the bits of the surrogate codeword that are changed due to the LDPC iterative decoding. In some examples, a list structure, an array, a vector, or a FIFO (First In, First Out) structure, may be used to store the relevant portions of the surrogate codeword. The processing circuitry may be configured to store 140 the bits of the surrogate codeword that are changed due to the LDPC iterative decoding within the memory structure using a list structure, e.g. using a linked list. The list structure may comprise the bits that were changed due to the LDPC iterative decoding, and links between the (populated) members of the list. The processing circuitry may be configured to provide an abstract access to the surrogate codeword via the list structure, e.g. by applying changes to the list structure in response to a change of the corresponding bit or bits of the surrogate codeword.

In addition to the split between the codeword and the surrogate codeword (for the variable bit nodes), the same principle may be applied to the check nodes. For example, the obtained syndrome may be stored in a further memory structure (e.g. flip flops/ram), and the changes to be applied to the syndrome may be stored separately from the syndrome within the further memory structure (e.g. as shown in Figs. 6 or 9). In other words, the processing circuitry may be configured to record (150 of Fig. 1c) changes to be applied to the syndrome due to the LDPC iterative decoding in the further memory structure. The processing circuitry may be configured to store the obtained syndrome using the further memory structure (i.e. within the further memory structure). For example, the obtained syndrome may be stored statically (without being changed during the LDPC iterative decoding) within the further memory structure. The processing circuitry may be configured to record changes to be applied to the syndrome separately from the obtained syndrome within the further memory structure. As shown in Fig. 1b, the LDPC decoder apparatus may comprise memory circuitry (i.e. memory, such as flip-flops or RAM) 18b for storing the further memory structure. For example, when accessing the respective bit of the syndrome / the respective check node, a combination (e.g. an exclusive or (XOR)) operation may be performed on the respective bit of the syndrome and a bit representing a change to be applied to the syndrome.

Similar to the storage of the surrogate codeword, one of two approaches may be chosen - all of the bits of the syndrome may be duplicated, or only the bits that have been changed may be stored. For example, the processing circuitry may be configured to store, for each bit of the syndrome, a further bit representing whether a change is to be applied to the respective bit of the syndrome. In other words, the further memory structure may comprise, for each bit of the syndrome, another bit for recording the changes to be applied to the syndrome. Alternatively, only changes might be stored (in addition to the static syndrome) the memory. For example, the processing circuitry may be configured to store, for each bit of the syndrome that is changed due to the LDPC iterative decoding (e.g. only for bits of the syndrome that are changed during the LDPC iterative decoding), a further bit indicating that a change is to be applied to the respective bit of the syndrome. Again, a list structure, an array, a vector, or a FIFO (First In, First Out) structure, may be used to record the changes. In other words, the processing circuitry may be configured to store the further bit indicating that a change is to be applied to the respective bit of the syndrome using a list structure.

The processing circuitry is configured to output the information representing the changes to be applied to the codeword via the output circuitry. For example, the processing circuitry may be configured to output the (entire) surrogate codeword (representing the changes to be applied to the codeword), or information about single bits to be changed in the codeword.

This information can subsequently be applied to the (actual) codeword to obtain the corrected codeword. The optional combination circuitry is configured to combine the output of the LDPC decode apparatus, e.g. the surrogate codeword, with the codeword. For example, the combination circuitry may be configured to combine the information representing the changes to be applied to the codeword (e.g. the surrogate codeword) with the codeword using an XOR combination. The LDPC decoder system may comprise memory for storing the codeword in the interim. The combination circuitry is configured to output the combination, i.e. the combination of the surrogate codeword and the codeword, i.e. the corrected codeword.

In various examples, the processing circuitry or means for processing 14 may be implemented using one or more processing units, one or more processing devices, any means for processing, such as a processor, a computer or a programmable hardware component being operable with accordingly adapted software. In other words, the described function of the processing circuitry or means for processing 14 may as well be implemented in software, which is then executed on one or more programmable hardware components. Such hardware components may comprise a general-purpose processor, a Digital Signal Processor (DSP), a micro-controller, etc. In some examples, the processing circuitry may be implemented using a field-programmable gate-array (FPGA). In various examples, however, the processing circuitry may be implemented by an application-specific integrated circuitry, using logical gates and memory cells that are purpose-built for providing the functionality of the processing circuitry.

An input, e.g. the input circuitry or input means 12 may correspond to an interface for receiving information, which may be in digital (bit) values according to a specified code, within a module, between modules or between modules of different entities. An output, e.g. the output circuitry or output means 16 may correspond to an interface for transmitting information, which may be represented by digital (bit) values according to a specified code or protocol, within a module, between modules, or between modules of different entities.

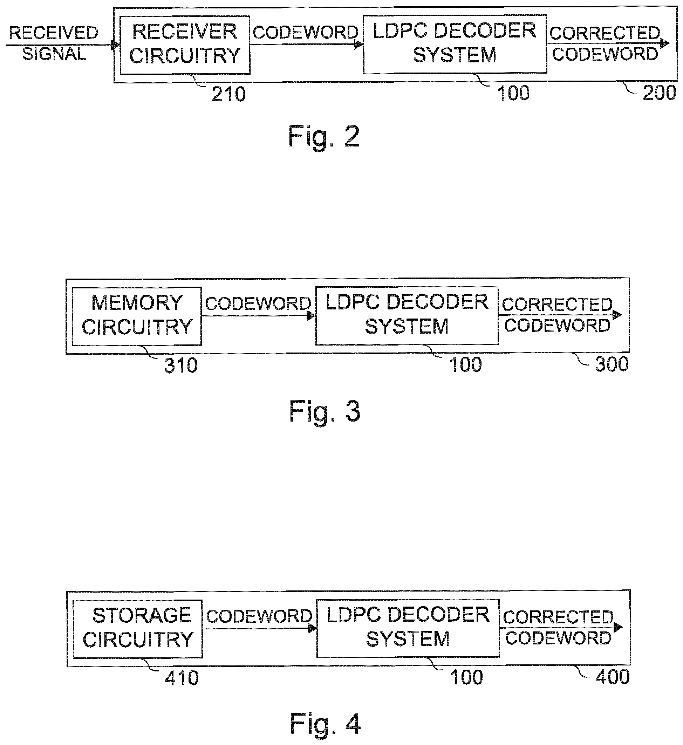

More details and aspects of the LDPC decoder apparatus, device, system, and method are mentioned in connection with the proposed concept or one or more examples described above or below (e.g. Fig. 2 to 13). The LDPC decoder apparatus, device, system, and method may comprise one or more additional optional features corresponding to one or more aspects of the proposed concept or one or more examples described above or below.

As has been mentioned before, LDPC-based decoding may be used in a variety of contexts. Therefore, in the following, a communication device, such as a wireless communication device or a wireline modem, a memory device and a storage device is introduced.

Fig. 2 shows a block diagram of an example of a communication device comprising an LDPC decoder system. The communication device 200 comprises receiver circuitry (or receiver means / means for receiving) 210 and the LDPC decoder system 100. The LDPC decoder system is configured to decode codewords received via the receiver circuitry. For example, the receive circuitry may be configured to receive signals comprising codewords using a wireless communication system (such as a Wireless Local Area Network, or a wireless communication system as defined by the third-generation partnership projection, 3GPP) or using a wireline communication system, e.g. using a cable communication system, a digital subscriber line communication system or using a passive optical network-based communication system. For example, the communication device may be a communication device for communicating via a passive optical network.

More details and aspects of the communication device are introduced in connection with the proposed concept or one or more examples described above or below (e.g. Fig. 1a to 1c, 3 to 13). The communication device may comprise one or more additional optional features corresponding to one or more aspects of the proposed concept or one or more examples described above or below.

Fig. 3 shows a block diagram of an example of a memory device comprising an LDPC decoder system. The memory device 300 comprises memory circuitry (or memory / memory means) 310, e.g. volatile memory or persistent memory, and the LDPC decoder system 100. The LDPC decoder system is configured to decode codewords obtained from the memory circuitry. For example, the memory device may be a Dual In-line Memory Module (DIMM), or a memory module having another form factor and/or connection infrastructure such as Compute Express Link (CXL), Peripheral Component Interconnect Express (PCIe) or NVMe (Non-Volatile Memory Express). In some examples, the memory device may be a persistent memory device, i.e. a memory device that enables a persistent storage of the information held in the memory. For example, the memory device may use three-dimensional cross-point memory, such as Intel^{®} 3D XPoint^{™}-based persistent memory.

In some examples, the memory device may be a memory device for implementing two-level memory (2LM). In some examples, where the memory device is configured as a 2LM system, the memory device 300 may serve as main memory for a computing device. For these examples, memory circuitry 310 may include the two levels of memory including cached subsets of system disk level storage. In this configuration, the main memory may include "near memory" arranged to include volatile types on memory and "far memory" arranged to include volatile or non-volatile types of memory. The far memory may include volatile or non-volatile memory that may be larger and possibly slower than the volatile memory included in the near memory. The far memory may be presented as "main memory" to an operating system (OS) for the computing device while the near memory is a cache for the far memory that is transparent to the OS. The management of the 2LM system may be done by a combination of logic and modules executed via processing circuitry (e.g., a CPU) of the computing device. Near memory may be coupled to the processing circuitry via high bandwidth, low latency means for efficient processing. Far memory may be coupled to the processing circuitry via low bandwidth, high latency means.

In some examples, the memory circuitry 310 may include non-volatile and/or volatile types of memory. Non-volatile types of memory may include, but are not limited to, 3-dimensional cross-point memory, flash memory, ferroelectric memory, silicon-oxide-nitride-oxide-silicon (SONOS) memory, polymer memory such as ferroelectric polymer memory, nanowire, ferroelectric transistor random access memory (FeTRAM or FeRAM), ovonic memory, nanowire or electrically erasable programmable read-only memory (EEPROM). Volatile types of memory may include, but are not limited to, dynamic random access memory (DRAM) or static RAM (SRAM).

More details and aspects of the memory device are introduced in connection with the proposed concept or one or more examples described above or below (e.g. Fig. 1a to 2, 4 to 13). The memory device may comprise one or more additional optional features corresponding to one or more aspects of the proposed concept or one or more examples described above or below.

Fig. 4 shows a block diagram of an example of a storage device comprising an LDPC decoder system. The storage device 400 comprises storage circuitry (or storage means / storage) 410, e.g. flash-based storage circuitry or solid-state storage circuitry, and the LDPC decoder system 100. The LDPC decoder system is configured to decode codewords obtained from the storage circuitry. For example, the storage device may be a solid-state storage device, e.g. a flash-based storage device, such as a solid-state drive. For example, the storage device may be a Compute Express Link (CXL)-, Peripheral Component Interconnect Express (PCIe)- or NVMe (Non-Volatile Memory Express)-based storage device. Other possible interfaces for storage devices include serial ATA (SATA), serial attached SCSI (SAS) or universal serial bus (USB). For example, the storage device may be configured to communicate with a host device via a bus, such as a Peripheral Component Interconnect (PCIe), Serial Advanced Technology Attachment (SATA), Serial Attached Small Computer System Interface (SAS)) or a network, such as the Internet, a storage area network (SAN), a local area network (LAN), etc. For example, the storage circuitry 410 may be implemented using non-volatile memory, such as 3-dimensional cross-point memory, flash memory, ferroelectric memory, silicon-oxide-nitride-oxide-silicon (SONOS) memory, polymer memory such as ferroelectric polymer memory, nanowire, ferroelectric transistor random access memory (FeTRAM or FeRAM), ovonic memory, nanowire or electrically erasable programmable read-only memory (EEPROM). In some examples, the storage circuitry 410 may also include types of storage mediums such as optical discs to include, but not limited to, compact discs (CDs), digital versatile discs (DVDs), a high definition DVD (HD DVD) or a Blu-ray disc.

More details and aspects of the storage device are introduced in connection with the proposed concept or one or more examples described above or below (e.g. Fig. 1a to 3, 5a to 13). The storage device may comprise one or more additional optional features corresponding to one or more aspects of the proposed concept or one or more examples described above or below.

Various examples of the present disclosure relate to a syndrome Input to LDPC Decoder.

A low-density parity-check code (LDPC) H matrix is sparse, so most of the elements are 0s, denoting lack of connections. Fig. 5a shows a schematic diagram of an interrelationship between an LDPC H matrix (comprising a first portion 510 for payload bits and a second portion 520 for parity bits), variable bit nodes 530 and check nodes 540. In this quasi-cyclic LDPC matrix example, the lines represent structured locations of non-zero elements. The parity-check (H) matrix can be thought of as connections between variable bit nodes and check nodes. The variable bit nodes correspond to the matrix columns and the codeword bits. The check nodes correspond to the matrix rows and the syndrome bits.

To begin decoding, in various systems, the codeword bits may be loaded into the variable bit nodes, which outnumber the check nodes. Then the check node values may be calculated by computing the syndrome by multiplying the values of the variable bit nodes by the H matrix. In different types of LDPC decoding (e.g. min-sum, bit flipping, belief propagation), messages are passed between the variable bit nodes and check nodes over multiple iterations until a codeword is found such that the variable bit nodes contain the corrected codeword and the check nodes contain all 0s indicating a zero syndrome value. Memory may be required to be stored for the variable bit nodes and the check nodes. An introduction to LDPC codes can be found in Sarah S. Johnson: "Introducing Low-Density Parity-Check Codes"

Fig. 5b shows a schematic diagram of an LDPC decoding flow. A (static) input codeword is input into a decoder 540, which is used to decode and find the corrected codeword, and to output the corrected codeword.

In 25G PON (Passive Optional Network), codewords may be required to complete in a certain time frame, and they may be queued up behind a codeword that takes longer to decode. In order to use a shared ECC (Error Correction Code) decoder, the received data may be queued up, which may cost storage elements and latency.

In some approaches, the full LDPC codeword is loaded into the LDPC decoder. There is increased latency due to inputting the codeword over multiple clock cycles. The LDPC decoder may require storage space to store a copy of the original codeword.

Various examples of the present disclosure may reduce the hardware and/or storage costs for the decoding on linear block codes. Second, multiple clock cycles may be required to input a codeword into an LDPC decoder. This can be a significant source of latency, especially when the number of bit errors is low. Various examples of the present disclosure may reduce the input latency to the LDPC decoder. Third, memory may be required to store the input codeword inside the LDPC decoder. Various examples of the present disclosure may reduce the amount of memory required inside the LDPC decoder.

In various examples, e.g. for hard-decision decoding, only the syndrome might be passed to the LDPC decoder (i.e. the LDPC decoder apparatus, device, or method). Instead of inputting the codeword bits, the syndrome bits may be input, which can be much smaller, and the syndrome bits may be stored in flip-flops. The input codeword bits might not be stored in flip-flops as the original codeword bits may all assumed to be zero. In another example, even the intermediate codeword bits might not be stored inside the bit flipping decoder.

There are typically more codeword bits than syndrome bits. Syndrome bits may be passed through multiple pipeline stages. It may reduce the input latency into the LDPC decoder as syndrome bits can be input in one clock cycle. It may also reduce congestion in the core decoding logic, as all of the codeword input values are hard-wired to zero. When there are multiple codewords queued up for decoding, the queue size can be smaller.

In various examples, the input ports to the min-sum decoder or bit-flipping decoder may be the size of the syndrome, which is also the number of parity bits. An SRAM approximately the same size as the LDPC codeword size may be omitted from the LDPC decoder. The output from the LDPC decoder may be XORed (combined with an Exclusive Or operation) with the full codeword, which may be stored in a FIFO (First In First Out) or SRAM (static RAM). Various examples may comprise standalone syndrome calculation block, e.g. syndrome generation circuitry, located prior to the decoder, e.g. the min-sum decoder or bit-flipping decoder, and may comprise many, many XOR gates.

For the bit flipping decoder with a changed memory structure, a syndrome calculator may be that calculates a syndrome and feeds into the bit flipping decoder. There might be no syndrome calculator inside the bit flipping decoder. There might only be enough flip flops in the bit flipping decoder to store the check nodes, but not enough flip-flops to store the variable nodes. If the decoder comprises a RAM (Random Access Memory) that stores codeword bits (variable nodes), its outputs might not be fed into the syndrome flip-flops.
In various examples, when an LDPC codeword is decoded, the input codeword and the bit flips may be handled separately. Since the LDPC codes are linear codes, the syndrome may depend (only) on the error vector (noise vector) and not on the input data (noise-free codeword). Throughout the iterative process of decoding and at the end of decoding, the partially and fully corrected codeword may be the sum of the input codeword and the bit flips.

Fig. 6 shows a schematic diagram of an example of another representation of an interrelationship between an LDPC H matrix, variable bit nodes 530; 630 and check nodes 540; 640. Compared to the representation of Fig. 5a, both the codeword (i.e. the variable bit nodes) and the check nodes may be split into two components. The variable check nodes may be split into a static codeword 530 and the bit flips during decoding 630. The check nodes may be split into a static input syndrome 540 and the changes to the syndrome from bit flips 640. The input codeword may be static and might not change, while the bit flips may be dynamic and may change throughout the iterative decoding process. There is a syndrome 540 that can be calculated from the input codeword and a syndrome 640 that can be calculated from the bit flips. The sum of the two syndromes may be the regular check node values. In other words, the check node values may be split into the input codeword syndrome 540 that is static and the changes to the syndrome from the bit flips 640 that are dynamic.

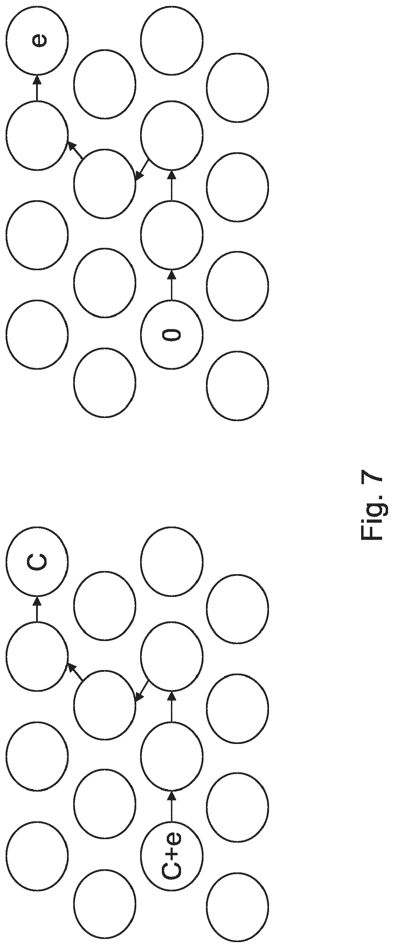

It may be noted that going from a noisy codeword to a corrected codeword may be considered equivalent to going from the zero codeword to an error vector. This is shown in the Fig. 7, where each bubble represents a vector of codeword bits. C represents the correct codeword and e represents the error vector, with C+e being the codeword with the error vector, and 0 being an all-zero codeword. Fig. 7 shows a schematic diagram of a similarity between a generation of an error vector and a correction of a corrupted codeword.

Various examples take advantage of this by calculating the syndrome for the input codeword first, and then continuing decoding without the input codeword, since its contribution is represented by the input codeword syndrome, and that may be sufficient to find the bit flip locations. The concept that the syndrome is sufficient to fully represent the error locations may be used in Hamming, SECDED (Single Error Correction, Double Error Detection), BCH (Bose-Chaudhuri-Hocquenghem) and Reed-Solomon decoding. A use of the concept for LDPC decoders might not be well-known, and the adaptation of the concept may require some modified memory structures.

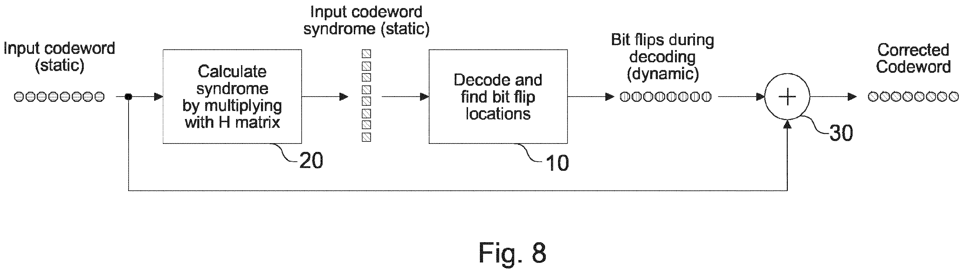

Two separate blocks may be used: one to calculate the input codeword syndrome (e.g. the syndrome generation circuitry 20), and one to perform LDPC decoding (e.g. the LDPC decoder apparatus 10). Fig. 8 shows a schematic diagram of an LDPC decoding flow according to an example. The input codeword may be input into a block 20 for calculating the input codeword syndrome by multiplying the codeword with the H matrix and result in the (static) input codeword syndrome, which may be input into a block 10 for decoding and finding bit flip locations, which may in turn output the bit flips during decoding (static), e.g. the information on the changes to be applied to the codeword. This information may be combined 30 (e.g. XORed) with the (static) input codeword, which may yield the corrected codeword. The input to the LDPC decoding block may input the input codeword syndrome instead of the input codeword, where the input codeword syndrome is much smaller. This approach may be mostly applicable to hard-decision decoding. It can also be used with soft decision decoding and decoding with errors and erasures decoding, but the input codeword soft information may be input into the decoder.

The decoder will be changed. The variable nodes might not need storage space to store the input intrinsic information, as all bits (of the surrogate codeword) logical 0s. The input may go directly to the input codeword syndrome storage in the check nodes. The check node storage may grow to store an additional set of syndrome sign bits for the input codeword syndrome. In other words, extra flip-flops may be added to each check node, e.g. for both the min-sum decoder and the bit flipping decoder.

Fig. 9 shows a schematic diagram of an example of another representation of an interrelationship between an LDPC H matrix, variable bit nodes and check nodes. Again the variable bit nodes are split into two components - a first component 930 of logical zeros for intrinsic information (static), and a second component 930 representing bit flips during decoding with extrinsic information (dynamic). The check nodes may be split into two components similar to the example of Fig. 6.

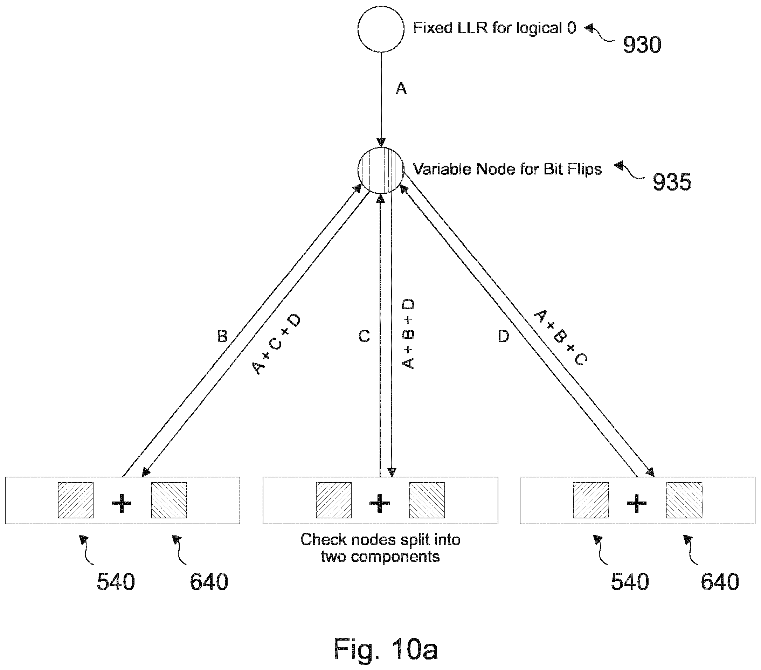

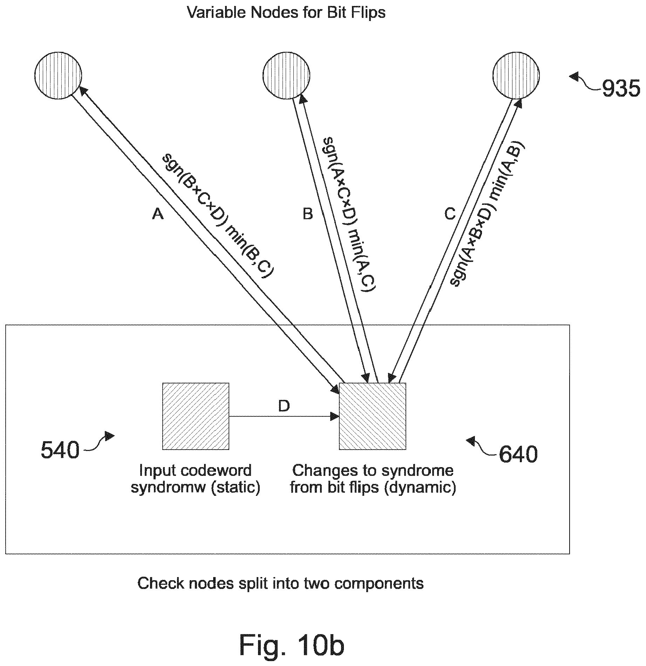

Fig. 10a shows a schematic diagram of an example of a variable node update logic for a min-sum decoder. The aim of min-sum decoding, which is a simplification of sum-product decoding, is to compute the maximum a posteriori probability (MAP) for each codeword bit that the codeword bit is a 1 under the condition of event N that all parity-check constraints are satisfied. So-called extrinsic information for the codeword bit is obtained from the parity checks. The min-sum algorithm iteratively computes an approximation of the MAP value for each code bit. In min-sum decoding the extrinsic message from a check node j to a variable bit node *i*, is the LLR (Log-Likelihood Ratio) of the probability that bit *i* causes parity-check *j* to be satisfied. In various examples, not only can the input codeword bit be hard-coded to a logical 0, the input to LLR mapping may also be replaced by a hard-coded log-likelihood (LLR) value that corresponds to logical 0. In Fig. 10a, the probabilities are denoted with letters A-D. In the example of Fig. 10a, the fixed LLR for logical 0 930 provides A to the variable node for bit flips 935, which exchanges messages with the variable check nodes 540; 640, e.g. by providing A+C+D in exchange for B with one pair of check nodes, by providing A+B+D in exchange for C with another pair of check nodes, and by providing A+B+C in exchange for D with another pair of check nodes. Fig. 10b shows a schematic diagram of an example of a check node update logic for a min-sum decoder. A single pair of check nodes comprising a static bit 540 from the input codeword syndrome and a dynamic bit 640 recording changes to the syndrome from bit flips exchanges messages with variable nodes for bit flips 935. The static bit 540 provides D to the dynamic bit 640. The dynamic bit receives D from the static bit, A from one of the variable nodes in exchange for *sgn*(*B* × *C* × *D*)*min*(*B,C*), B from another variable node in exchange for *sgn*(*A* × *C* × *D*)*min*(*A, C*), and C from another variable node in exchange for *sgn*(*A* × *B* × *D*)*min*(*A, B*).

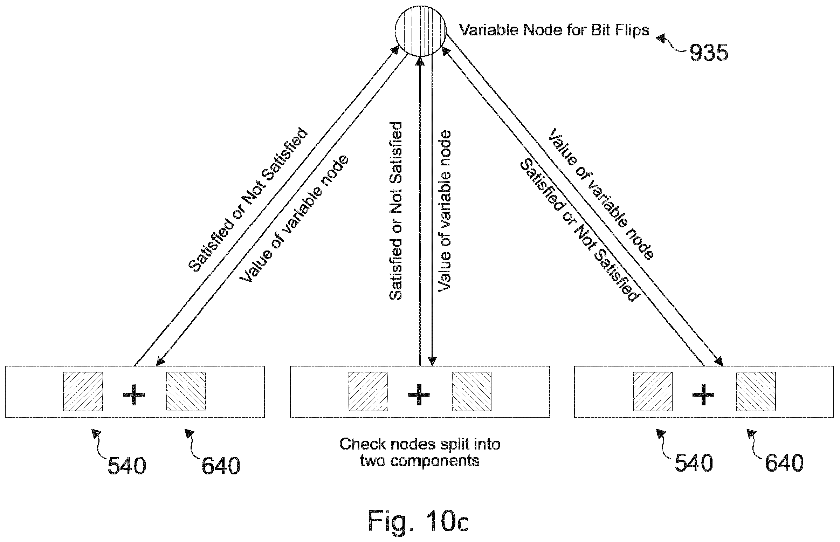

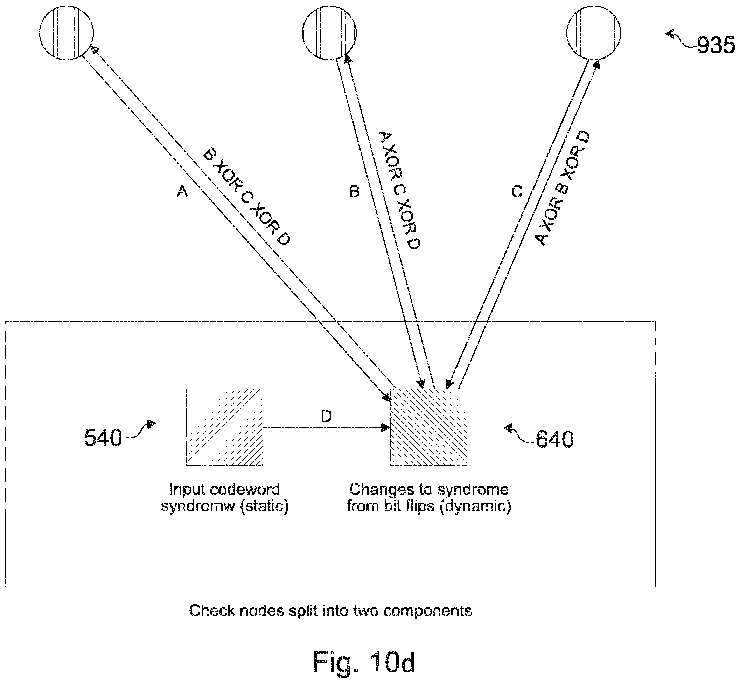

Fig. 10c shows a schematic diagram of an example of a variable node update logic for a bit-flipping decoder. A variable node for bit flips 935 exchanges messages with three pairs of check nodes (each split into two components 540; 640), with the variable node for bit flips sending a message indicating the new value of the variable node, either 0 or 1, and the pair of check nodes replying with a "satisfied" for "not satisfied". Fig. 10d shows a schematic diagram of an example of a check node update logic for a bit-flipping decoder. A single pair of check nodes comprising a static bit 540 from the input codeword syndrome and a dynamic bit 640 recording changes to the syndrome from bit flips exchanges messages with variable nodes for bit flips 935. The static bit 540 provides D to the dynamic bit 640. The dynamic bit receives D from the static bit, A from one of the variable nodes in exchange for B XOR C XOR D, B from another variable node in exchange for A XOR C XOR D, and C from another variable node in exchange for A XOR B XOR D.

It may be noted that the syndrome input to the LDPC decoder also works with soft decoding with different LLRs. In that case, the sign bits for each variable node may not need to be stored, and extra sign bits may be stored for each check node. The reliability or soft information may be input to the decoder as before.

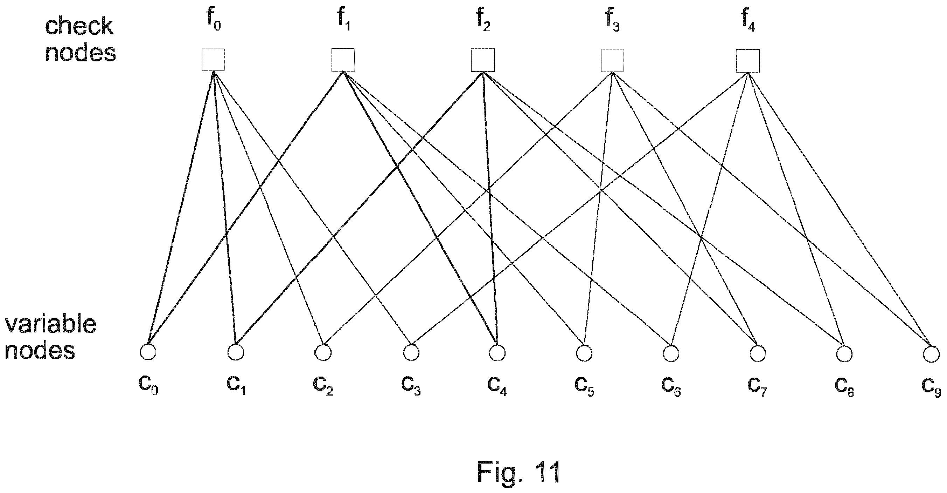

In the following, an approach is introduced in which the memory structure is changed even further. Some low-complexity LDPC decoders include majority logic decoders and bit-flipping decoders. These flip bits in the LDPC codeword when a variable node, that is associated with a codeword bit, is determined to be an error. The LDPC code can be represented by a Tanner graph, where there are variable nodes (c₀ to c₉ in Fig. 11) that represent codeword bits and check nodes (f₀ to f₄ in Fig. 11) that represent parity-check equations. Each variable node and check node contains a single bit, representing 0 or 1. The variable node is determined to be in error if many of its connected check nodes represent failed parity-check equations. Fig. 11 shows a Tanner graph representing an LDPC code.

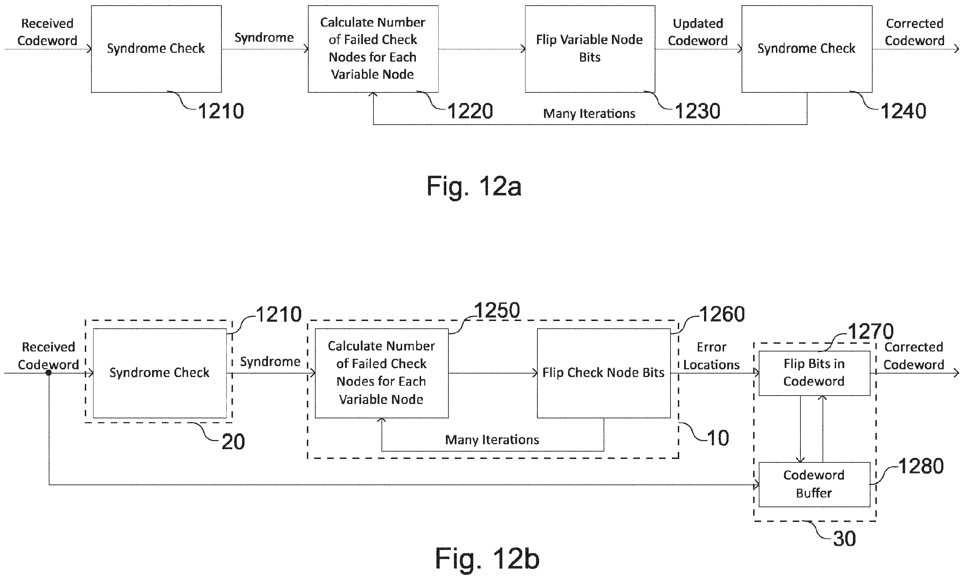

After the bits are flipped following certain rules, the parity-check equations may be recalculated to verify whether all of the equations pass. When all of the parity-check equations pass, decoding may be successful. Computing the parity-check equations is also called a syndrome check. When all of the equations pass, the check nodes all have the value 0. The aggregation of the check nodes is called the syndrome. So both of these decoding methods require 1) one syndrome check, 2) logic to determine status of a variable node based on check nodes, and 3) a second syndrome check. Fig. 12a shows an exemplary flow of a low-complexity LDPC decoder. In a syndrome check block 1210 a syndrome check is performed on a received codeword to generate the syndrome. In a subsequent block 1220 the number of failed check nodes is calculated for each variable node. In a subsequent block 1230, the respective variable node bits are flipped. In a further syndrome check block 1240 the resulting updated codeword is check by calculating the syndrome. If the syndrome indicates, that the codeword is not correct (e.g. if the syndrome contains logical ones), the LDPC decoder returns to block 1220 (for many iterations), if the syndrome indicates, that the codeword is correct, the corrected codeword is provided. If the syndrome is not 0, these algorithms may be repeated over several iterations. Because the syndrome is re-evaluated, usually there is a requirement to store the variable nodes in memory.

Another approach taken in the present disclosure is to decode the LDPC codeword by storing the check node bits, which correspond to the syndrome, and saving bit flips as a vector of locations. A main difference between this and regular bit flipping algorithms is how memory is used. For example, the current value of each variable node may be stored in flip-flops or RAM. In a proposed algorithm, the syndrome may be first calculated, and the received codeword bits may be stored elsewhere to be corrected later. While much of the combinational logic remains the same, to identify which bits should flip, the associated syndrome bits may be flipped while the new bit is not stored immediately in the variable node. Instead, an error location is added to a vector of error locations (i.e. to record the changes to be applied to the codeword). This may reduce the memory directly accessed by the core bit flipping algorithm to the number of check nodes, which is often ten times smaller than the number of variable nodes. Afterwards, the error locations stored in the error location vector can be used to correct the codeword stored elsewhere. Alternatively, the (surrogate) codeword can be modified as each error location is found, but the codeword might not be an input to the bit flipping algorithm. In regular bit flipping algorithms, the updated codeword may be used to recalculate the syndrome, but that might not be necessary in the proposed implementation. The algorithm is as follows and illustrated in Fig. 12b Fig. 12b shows a flow of an LDPC decoder according to an example, e.g. an LDPC decoder that uses a syndrome-based bit flipping algorithm. 1) the syndrome may be calculated (e.g. by a syndrome check block 1210) and stored in the check nodes as 0s and 1s. 2) For each variable node, the 1s in the associated check nodes may be counted to obtain a sum for each variable node (e.g. in a subsequent block 1250). 3) If the sum exceeds a specified threshold, the associated check node bits need to be flipped and a bit flip location is stored in a vector (e.g. in a flip check node bits block 1260). 4) 2 and 3 may be repeated (over many iterations) until all of the check node bits are 0 or if the number of iterations exceeds a specified limit. If there have been no bit flips for any of the variable nodes during a full iteration and the threshold greater than a specified minimum threshold, 2 and 3 may be repeated using a reduced threshold required to flip the bit. If the threshold is already at a specified minimum value and there are no bit flips, the algorithm may continue 5). 5) Retrieve codeword bits from the Codeword Buffer 1280 and flip the bits in the codeword (in a block 1270). For example, the syndrome generation circuitry 20 may implement the syndrome check block 1210, the LDPC decoder apparatus 10 may comprise blocks 1250 and 1260, and the combination circuitry 30 may implement the flip bits in codeword block 1270.

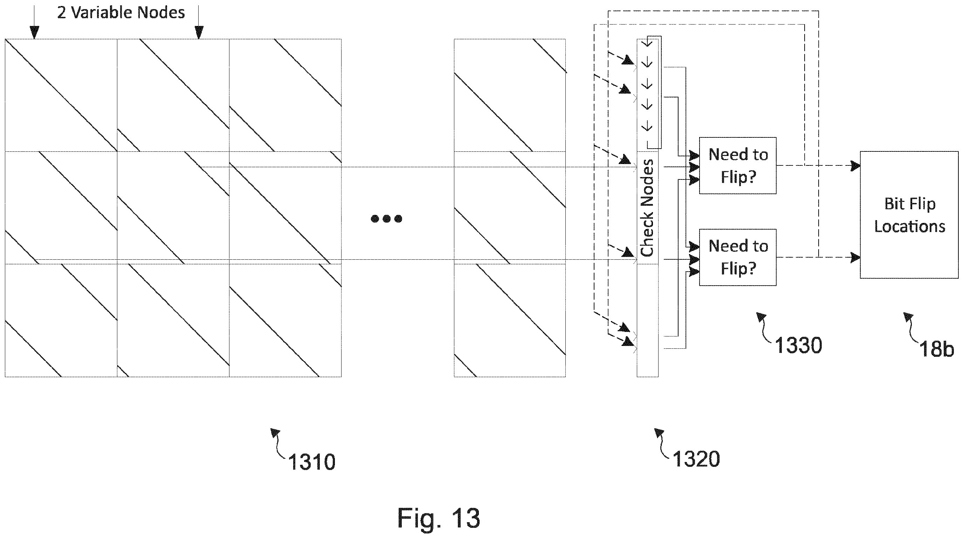

In one implementation, a rotating check node register may be used. Fig. 13 shows a schematic diagram of an example of an architecture of a syndrome-based bit flipping algorithm. Let each circulant in the H matrix be a *c* × *c* submatrix, as shown with the divisions in the H matrix 1310 in Fig. 13. The check nodes 1320 may be arranged into groups of *c* check nodes, and they may rotate (as indicated by the arrows in Fig. 13) within the groups at each clock cycle. There may be logic that is hard-coded to correspond to add the check node bits that correspond to one variable node in each group of *c* variable nodes. In *c* clock cycles, the checks for all variable nodes may be completed. If any variable node's associated check nodes meet criteria for a bit flip, then those associated check nodes may be flipped (by block 1330). An explicit syndrome calculation might not be necessary, because the syndrome is already in the check nodes. The bit flip locations may be recorded in a memory 18b. Because the syndrome is always available, it may be possible in some cases to detect a zero syndrome, which means all of the bit errors have been found, and thereby finish decoding before going through one full iteration of checking all the variable nodes.

The aspects and features described in relation to a particular one of the previous examples may also be combined with one or more of the further examples to replace an identical or similar feature of that further example or to additionally introduce the features into the further example.

Example 1 relates to a low-density parity-check code, LDPC, decoder apparatus (10), comprising input circuitry (12) and processing circuitry (14), the processing circuitry being configured to obtain a syndrome of a codeword via the input circuitry, perform LDPC iterative decoding using the obtained syndrome, wherein the changes to be applied to the codeword due to the LDPC iterative decoding are recorded by applying the changes to a surrogate codeword, and record changes to be applied to the codeword due to the LDPC iterative decoding by storing the surrogate codeword in a memory structure.

In Example 2, the subject matter of example 1 or any of the Examples described herein may further include, that the memory structure for recording the changes to be applied to the codeword is used to store each bit of the surrogate codeword.

In Example 3, the subject matter of one of the examples 1 to 2 or any of the Examples described herein may further include, that the memory structure for recording the changes to be applied to the codeword is used to store the bits of the surrogate codeword that are changed due to the LDPC iterative decoding.

In Example 4, the subject matter of example 3 or any of the Examples described herein may further include, that the processing circuitry is configured to store the bits of the surrogate codeword that are changed due to the LDPC iterative decoding within the memory structure using a list structure.

In Example 5, the subject matter of one of the examples 1 to 4 or any of the Examples described herein may further include, that the processing circuitry is configured to record changes to be applied to the syndrome due to the LDPC iterative decoding in a further memory structure.

In Example 6, the subject matter of example 5 or any of the Examples described herein may further include, that the processing circuitry is configured to store the obtained syndrome using the further memory structure, and to record changes to be applied to the syndrome separately from the obtained syndrome within the further memory structure.

In Example 7, the subject matter of example 6 or any of the Examples described herein may further include, that the processing circuitry is configured to store, for each bit of the syndrome, a further bit representing whether a change is to be applied to the respective bit of the syndrome.

In Example 8, the subject matter of example 6 or any of the Examples described herein may further include, that the processing circuitry is configured to store, for each bit of the syndrome that is changed due to the LDPC iterative decoding, a further bit indicating that a change is to be applied to the respective bit of the syndrome.

In Example 9, the subject matter of example 8 or any of the Examples described herein may further include, that the processing circuitry is configured to store the further bit indicating that a change is to be applied to the respective bit of the syndrome using one of a list structure, an array, a vector or a FIFO structure.

In Example 10, the subject matter of one of the examples 1 to 9 or any of the Examples described herein may further include, that the surrogate codeword is used by the processing circuitry for the LDPC iterative decoding instead of the codeword.

In Example 11, the subject matter of one of the examples 1 to 10 or any of the Examples described herein may further include, that the LDPC iterative decoding is performed using one of a belief propagation algorithm, a sum-product message-passing algorithm, a min-sum algorithm, a bit-flipping algorithm, a min-max algorithm, an extended min-sum algorithm, a trellis min-sum algorithm, a symbol flipping algorithm, or a non-binary stochastic decoder.

In Example 12, the subject matter of one of the examples 1 to 11 or any of the Examples described herein may further include, that the surrogate codeword is initialized with all zeros during an initialization of the LDPC iterative decoding.

In Example 13, the subject matter of one of the examples 1 to 12 or any of the Examples described herein may further include, that the LDPC decoder apparatus further comprises output circuitry, wherein the processing circuitry is configured to output information representing the changes to be applied to the codeword via the output circuitry.

Example 14 relates to a low-density parity-check code, LDPC, decoder system (100) comprising a LDPC decoder apparatus (10) according to one of the examples 1 to 13. The low-density parity-check code comprises syndrome generation circuitry (20) configured to generate a syndrome based on a codeword, and to provide the syndrome to the LDPC decoder apparatus. The low-density parity-check code comprises combination circuitry (30) configured to combine an output of the LDPC decoder apparatus with the codeword, and to output the combination.

In Example 15, the subject matter of example 14 or any of the Examples described herein may further include, that the LDPC decoder system further comprises receiver circuitry (210), wherein the LDPC decoder system is configured to decode codewords received via the receiver circuitry.

In Example 16, the subject matter of example 15 or any of the Examples described herein may further include, that the LDPC decoder system is a communication device for communicating via a passive optical network,

Example 17 relates to a communication device (200) comprising receiver circuitry (210) and a low-density parity-check code, LDPC, decoder system (100) according to example 14, wherein the LDPC decoder system is configured to decode codewords received via the receiver circuitry.

In Example 18, the subject matter of example 17 or any of the Examples described herein may further include, that the communication device is a communication device for communicating via a passive optical network.

Example 19 relates to a memory device (300) comprising memory circuitry (310) and a low-density parity-check code, LDPC, decoder system (100) according to example 14, wherein the LDPC decoder system is configured to decode codewords obtained from the memory circuitry.

Example 20 relates to a storage device (400) comprising storage circuitry (410) and a low-density parity-check code, LDPC, decoder system (100) according to example 14, wherein the LDPC decoder system is configured to decode codewords obtained from the storage circuitry.

Example 21 relates to a low-density parity-check code, LDPC, decoder device (10), comprising input means (12) and means for processing (14), the means for processing being configured to obtain a syndrome of a codeword via the input means, perform LDPC iterative decoding using the obtained syndrome, wherein the changes to be applied to the codeword due to the LDPC iterative decoding are recorded by applying the changes to a surrogate codeword, and record changes to be applied to the codeword due to the LDPC iterative decoding by storing the surrogate codeword in a memory structure.

In Example 22, the subject matter of example 21 or any of the Examples described herein may further include, that the memory structure for recording the changes to be applied to the codeword is used to store each bit of the surrogate codeword.

In Example 23, the subject matter of one of the examples 21 to 22 or any of the Examples described herein may further include, that the memory structure for recording the changes to be applied to the codeword is used to store the bits of the surrogate codeword that are changed due to the LDPC iterative decoding.

In Example 24, the subject matter of example 23 or any of the Examples described herein may further include, that the means for processing is configured to store the bits of the surrogate codeword that are changed due to the LDPC iterative decoding within the memory structure using a list structure.

In Example 25, the subject matter of one of the examples 21 to 24 or any of the Examples described herein may further include, that the means for processing is configured to record changes to be applied to the syndrome due to the LDPC iterative decoding in a further memory structure.

In Example 26, the subject matter of example 25 or any of the Examples described herein may further include, that the means for processing is configured to store the obtained syndrome using the further memory structure, and to record changes to be applied to the syndrome separately from the obtained syndrome within the further memory structure.

In Example 27, the subject matter of example 26 or any of the Examples described herein may further include, that the means for processing is configured to store, for each bit of the syndrome, a further bit representing whether a change is to be applied to the respective bit of the syndrome.

In Example 28, the subject matter of example 26 or any of the Examples described herein may further include, that the means for processing is configured to store, for each bit of the syndrome that is changed due to the LDPC iterative decoding, a further bit indicating that a change is to be applied to the respective bit of the syndrome.

In Example 29, the subject matter of example 28 or any of the Examples described herein may further include, that the means for processing is configured to store the further bit indicating that a change is to be applied to the respective bit of the syndrome using one of a list structure, an array, a vector or a FIFO structure.

In Example 30, the subject matter of one of the examples 21 to 29 or any of the Examples described herein may further include, that the surrogate codeword is used by the means for processing for the LDPC iterative decoding instead of the codeword.

In Example 31, the subject matter of one of the examples 21 to 30 or any of the Examples described herein may further include, that the LDPC iterative decoding is performed using one of a belief propagation algorithm, a sum-product message-passing algorithm, a min-sum algorithm, a bit-flipping algorithm, a min-max algorithm, an extended min-sum algorithm, a trellis min-sum algorithm, a symbol flipping algorithm, or a non-binary stochastic decoder.

In Example 32, the subject matter of one of the examples 1 to 11 or any of the Examples described herein may further include, that the surrogate codeword is initialized with all zeros during an initialization of the LDPC iterative decoding.

In Example 33, the subject matter of one of the examples 1 to 12 or any of the Examples described herein may further include, that the LDPC decoder device further comprises output means, wherein the means for processing is configured to output information representing the changes to be applied to the codeword via the output means.

Example 34 relates to a low-density parity-check code, LDPC, decoder system (100) comprising a LDPC decoder device (10) according to one of the examples 21 to 33. The low-density parity-check code comprises syndrome generation means (20) configured to generate a syndrome based on a codeword, and to provide the syndrome to the LDPC decoder device. The low-density parity-check code comprises combination means (30) configured to combine an output of the LDPC decoder device with the codeword, and to output the combination.

In Example 35, the subject matter of example 34 or any of the Examples described herein may further include, that the LDPC decoder system further comprises means for receiving (210), wherein the LDPC decoder system is configured to decode codewords received via the means for receiving.

In Example 36, the subject matter of example 35 or any of the Examples described herein may further include, that the LDPC decoder system is a communication device for communicating via a passive optical network,

Example 37 relates to a communication device (200) comprising means for receiving (210) and a low-density parity-check code, LDPC, decoder system (100) according to example 34, wherein the LDPC decoder system is configured to decode codewords received via the means for receiving.

In Example 38, the subject matter of example 37 or any of the Examples described herein may further include, that the communication device is a communication device for communicating via a passive optical network.

Example 39 relates to a memory device (300) comprising memory (310) and a low-density parity-check code, LDPC, decoder system (100) according to example 34, wherein the LDPC decoder system is configured to decode codewords obtained from the memory.

Example 40 relates to a storage device (400) comprising storage (410) and a low-density parity-check code, LDPC, decoder system (100) according to example 34, wherein the LDPC decoder system is configured to decode codewords obtained from the storage.

Example 41 relates to a low-density parity-check code, LDPC, decoder method, comprising obtaining (120) a syndrome of a codeword via an input. The low-density parity-check code comprises performing LDPC iterative decoding (130) using the obtained syndrome, wherein the changes to be applied to the codeword due to the LDPC iterative decoding are recorded by applying the changes to a surrogate codeword. The low-density parity-check code comprises recording changes (140) to be applied to the codeword due to the LDPC iterative decoding by storing the surrogate codeword in a memory structure.

In Example 42, the subject matter of example 41 or any of the Examples described herein may further include, that the memory structure for recording the changes to be applied to the codeword is used to store each bit of the surrogate codeword.

In Example 43, the subject matter of one of the examples 41 to 42 or any of the Examples described herein may further include, that the memory structure for recording the changes to be applied to the codeword is used to store the bits of the surrogate codeword that are changed due to the LDPC iterative decoding.

In Example 44, the subject matter of example 43 or any of the Examples described herein may further include, that the method comprises storing (140) the bits of the surrogate codeword that are changed due to the LDPC iterative decoding within the memory structure using a list structure.

In Example 45, the subject matter of one of the examples 41 to 44 or any of the Examples described herein may further include, that the method comprises recording (150) changes to be applied to the syndrome due to the LDPC iterative decoding in a further memory structure.

In Example 46, the subject matter of example 45 or any of the Examples described herein may further include, that the method comprises storing (122) the obtained syndrome using the further memory structure, and recording (150) changes to be applied to the syndrome separately from the obtained syndrome within the further memory structure.

In Example 47, the subject matter of example 46 or any of the Examples described herein may further include, that the method comprises storing (150), for each bit of the syndrome, a further bit representing whether a change is to be applied to the respective bit of the syndrome.

In Example 48, the subject matter of example 46 or any of the Examples described herein may further include, that the method comprises storing (150), for each bit of the syndrome that is changed due to the LDPC iterative decoding, a further bit indicating that a change is to be applied to the respective bit of the syndrome.

In Example 49, the subject matter of example 48 or any of the Examples described herein may further include, that the method comprises storing (150) the further bit indicating that a change is to be applied to the respective bit of the syndrome using one of a list structure, an array, a vector or a FIFO structure.

In Example 50, the subject matter of one of the examples 41 to 49 or any of the Examples described herein may further include, that the surrogate codeword is used by the method for the LDPC iterative decoding instead of the codeword.

In Example 51, the subject matter of one of the examples 41 to 50 or any of the Examples described herein may further include, that the LDPC iterative decoding is performed using one of a belief propagation algorithm, a sum-product message-passing algorithm, a min-sum algorithm, a bit-flipping algorithm, a min-max algorithm, an extended min-sum algorithm, a trellis min-sum algorithm, a symbol flipping algorithm, or a non-binary stochastic decoder.

In Example 52, the subject matter of one of the examples 41 to 51 or any of the Examples described herein may further include, that the surrogate codeword is initialized with all zeros during an initialization of the LDPC iterative decoding.

In Example 53, the subject matter of one of the examples 41 to 52 or any of the Examples described herein may further include, that the method comprises outputting (160) information representing the changes to be applied to the codeword via an output.

Example 54 relates to a low-density parity-check code, LDPC, decoder method comprising generating (110) a syndrome based on a codeword. The low-density parity-check code comprises using (120-160) the LDPC decoder method of one of the examples 41 to 53 with the generated syndrome. The low-density parity-check code comprises combining (170) the output of the LDPC decoder method with the codeword. The low-density parity-check code comprises outputting (180) the combination.

Example 55 relates to a communication device (200) comprising receiver circuitry (210), the communication device being configured to perform the low-density parity-check code, LDPC, decoder method according to example 54, wherein the LDPC decoder method is used to decode codewords received via the receiver circuitry.

In Example 56, the subject matter of example 55 or any of the Examples described herein may further include, that the communication device is a communication device for communicating via a passive optical network.

Example 57 relates to a memory device (300) comprising memory circuitry (310), the memory device being configured to perform the low-density parity-check code, LDPC, decoder method according to example 54, wherein the LDPC decoder method is used to decode codewords obtained from the memory circuitry.

Example 58 relates to a storage device (400) comprising storage circuitry (410), the storage device being configured to perform the low-density parity-check code, LDPC, decoder method according to example 54, wherein the LDPC decoder method is used to decode codewords obtained from the storage circuitry.

Example 59 relates to a machine-readable storage medium including program code, when executed, to cause a machine to perform the method of one of the examples 41 to 54.

Example 60 relates to a computer program having a program code for performing the method of one of the examples 41 to 54, when the computer program is executed on a computer, a processor, or a programmable hardware component.

Example 61 relates to a machine-readable storage including machine readable instructions, when executed, to implement a method or realize an apparatus as claimed in any pending claim or shown in any example.

Examples may further be or relate to a (computer) program including a program code to execute one or more of the above methods when the program is executed on a computer, processor, or other programmable hardware component. Thus, steps, operations, or processes of different ones of the methods described above may also be executed by programmed computers, processors, or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process, or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A low-density parity-check code, LDPC, decoder apparatus, comprising:
input circuitry and processing circuitry, the processing circuitry being configured to:
obtain a syndrome of a codeword via the input circuitry,
perform LDPC iterative decoding using the obtained syndrome, wherein the changes to be applied to the codeword due to the LDPC iterative decoding are recorded by applying the changes to a surrogate codeword, and
record changes to be applied to the codeword due to the LDPC iterative decoding by storing the surrogate codeword in a memory structure.

2. The LDPC decoder apparatus according to claim 1, wherein the memory structure for recording the changes to be applied to the codeword is used to store each bit of the surrogate codeword.

3. The LDPC decoder apparatus according to one of the previous claims, wherein the memory structure for recording the changes to be applied to the codeword is used to store the bits of the surrogate codeword that are changed due to the LDPC iterative decoding.

4. The LDPC decoder apparatus according to claim 3, wherein the processing circuitry is configured to store the bits of the surrogate codeword that are changed due to the LDPC iterative decoding within the memory structure using a list structure.

5. The LDPC decoder apparatus according to one of the previous claims, wherein the processing circuitry is configured to record changes to be applied to the syndrome due to the LDPC iterative decoding in a further memory structure.

6. The LDPC decoder apparatus according to claim 5, wherein the processing circuitry is configured to store the obtained syndrome using the further memory structure, and to record changes to be applied to the syndrome separately from the obtained syndrome within the further memory structure.

7. The LDPC decoder apparatus according to claim 6, wherein the processing circuitry is configured to store, for each bit of the syndrome, a further bit representing whether a change is to be applied to the respective bit of the syndrome.

8. The LDPC decoder apparatus according to claim 6 or 7, wherein the processing circuitry is configured to store, for each bit of the syndrome that is changed due to the LDPC iterative decoding, a further bit indicating that a change is to be applied to the respective bit of the syndrome.

9. The LDPC decoder apparatus according to claim 8, wherein the processing circuitry is configured to store the further bit indicating that a change is to be applied to the respective bit of the syndrome using one of a list structure, an array, a vector or a FIFO structure.

10. The LDPC decoder apparatus according to one of the previous claims, wherein the surrogate codeword is used by the processing circuitry for the LDPC iterative decoding instead of the codeword.

11. A low-density parity-check code, LDPC, decoder system comprising:
a LDPC decoder apparatus according to one of the previous claims;
syndrome generation circuitry configured to generate a syndrome based on a codeword, and to provide the syndrome to the LDPC decoder apparatus; and
combination circuitry configured to combine an output of the LDPC decoder apparatus with the codeword, and to output the combination.

12. The LDPC decoder system according to claim 11, further comprising receiver circuitry, wherein the LDPC decoder system is configured to decode codewords received via the receiver circuitry.

13. The LDPC decoder system according to claim 11 or 12, wherein the LDPC decoder system is a communication device for communicating via a passive optical network.

14. A low-density parity-check code (LDPC) decoder method, comprising:
obtaining a syndrome of a codeword via an input;
performing LDPC iterative decoding using the obtained syndrome, wherein the changes to be applied to the codeword due to the LDPC iterative decoding are recorded by applying the changes to a surrogate codeword; and
recording changes to be applied to the codeword due to the LDPC iterative decoding by storing the surrogate codeword in a memory structure.

15. A computer program having a program code for performing the method of claim 14, when the computer program is executed on a computer, a processor, or a programmable hardware component.
